(19) **Europäisches Patentamt**
**European Patent Office**
**Office européen des brevets**

(11) **EP 1 456 958 B1**

(12) **EUROPEAN PATENT SPECIFICATION**

(45) Date of publication and mention
of the grant of the patent:
**22.09.2010 Bulletin 2010/38**

(51) Int Cl.:
**H03M 13/41** (2006.01)

(21) Application number: **02781351.8**

(22) Date of filing: **27.11.2002**

(86) International application number:
**PCT/FI2002/000955**

(87) International publication number:
**WO 2003/052943 (26.06.2003 Gazette 2003/26)**

(54) **METHOD AND ARRANGEMENT FOR ENHANCING SEARCH THROUGH TRELLIS**

VERFAHREN UND ANORDNUNG ZUM ERWEITERN DER SUCHE DURCH TRELLIS

PROCEDE ET SYSTEME PERMETTANT D'AMELIORER L'EXPLORATION D'UN TREILLIS

(84) Designated Contracting States:
**AT BE BG CH CY CZ DE DK EE ES FI FR GB GR
IE IT LI LU MC NL PT SE SK TR**

(30) Priority: **17.12.2001 FI 20012487**

(43) Date of publication of application:
**15.09.2004 Bulletin 2004/38**

(73) Proprietor: **Nokia Corporation
02150 Espoo (FI)**

(72) Inventors:
• **SIPILÄ, Teemu
FIN-90460 Oulunsalo (FI)**
• **PARVIAINEN, Jari
FIN-90940 Jääli (FI)**

(74) Representative: **Brockman, Pertti Erik
Kolster Oy Ab,
Iso Roobertinkatu 23
P.O. Box 148
00121 Helsinki (FI)**

(56) References cited:
**US-A- 5 901 182**

• **BENGOUGH, P.A. ET AL.: 'Sorting-based VLSI architectures for the M-algorithm and T-algorithm trellis decoders' IEEE TRANSACTIONS ON COMMUNMICATIONS vol. 43, no. 2/3/4, February 1995, pages 514 - 522, XP000506556**
• **SHIN, S.K. ET AL.: 'Evaluation of block turbo code performance with the reduced search trellis decoding method' IEEE PROCEEDINGS ON COMMUNICATIONS vol. 148, no. 3, June 2001, pages 125 - 131, XP001065170**

**Description**

The invention relates to a method and arrangement for enhancing a search through a trellis, in which at each stage of the trellis a certain set of state indexes of the stage are selected for continuation.

BACKGROUND

The channel used in telecommunications systems often causes interference to data transmission. Interference occurs in all kinds of systems, but especially in wireless telecommunications systems, the transmission path attenuates and distorts in many different ways the signal being transmitted. The multipath propagation of the signal, different fades and reflections, and other signals being transmitted on the same transmission path typically cause interference on the transmission path.

To reduce the impact of the interference, several coding methods have been developed to protect signals from interference and to correct erroneous bits. Convolutional coding is a widely used coding method. In convolutional coding, the signal to be transmitted that is made up of symbols is coded into code words that are based on the convolution of the symbols to be transmitted either with themselves or with another signal. The coding ratio and generator polynomials define the convolutional code. The coding ratio (k/n) refers to the number (n) of the produced coded symbols in relation to the number (k) of the symbols to be coded. The encoder is typically implemented by means of a shift register and xoring devices. The constraint length (K) of a code often refers to the length of the shift register. The encoder can be considered a state machine having $2^{K-1}$ states.

A receiver decodes the encoded signal that propagated through the channel. A convolutional code is usually decoded using a trellis whose nodes describe the states of the encoder used in coding the signal, and the paths between the nodes belonging to different stages of the trellis describe the allowed state transitions. A decoder tries to find out the consecutive states of the encoder, i.e. the transitions from one state to another. To find out the transitions, the decoder calculates metrics, of which there are two types: path metrics (or state metrics) and branch metrics. Path metrics represent the probability of the set of symbols in the received signal leading to the state described by the node in question. Branch metrics represent the probabilities of different transitions.

A convolutional code is usually decoded by means of the Viterbi algorithm. The Viterbi algorithm is a computationally demanding task. A general problem with the Viterbi algorithm is that when the constraint length is long (e.g. 9, as in WCDMA of the UMTS system), the Viterbi algorithm must search through $2^{(9-1)}$, i.e. 256, states to decode one bit. Efficient signal processing algorithms are still being searched for wireless telecommunications systems in particular, in which the aim is to minimize the size and power consumption of subscriber terminals. A computationally efficient algorithm for speech or data decoding is the M algorithm that is a search algorithm simplified from the Viterbi algorithm. Using the M algorithm makes it possible to reduce the number of searched states, because only the M best paths are selected for continuation in the trellis stages instead of all paths. When a suitable value is selected for M, the performance of the decoder does not, however, degrade significantly. For instance, in the above-mentioned system, M can obtain the value 128, i.e. half of the possible paths are selected for continuation at each stage.

One problem with the use of the M algorithm is the selection of paths for continuation amongst all paths. Typically, the sorting of n elements requires $n^2/2$ comparison operations, and this is a computationally demanding task. Let us assume that the decoding of one bit by DSP (digital signal processing) in WCDMA requires approximately 500 clock cycles when a full search algorithm is used. If the M algorithm is used, the number of states to be searched is smaller but correspondingly, sorting increases the complexity. When sorting 16 elements, 128 comparison operations are required. Thus using the M algorithm with the best 16 paths leads to almost the same complexity as a full search algorithm. If a 256-state code is used, a full sort requires $n^2/2$, i.e. 32768 comparisons. A full search is too complex an operation to implement by the traditional methods.

One known solution for implementing the M algorithm is disclosed in publication S.J. Simmons: A Nonsorting VLSI structure for implementing the (M,L) algorithm, IEEE Journal on Selected Areas in Communications, Vol. 6, No. 3, April 1988, pages 538 to 546. The disclosed solution does not perform the actual sorting, but examines several different path metrics at the same time, starting from the most significant bit. While the different paths are examined, decisions are made on keeping or rejecting the routes. If the examined route is opposite to an already selected route, it is rejected. However, the solution disclosed in the publication works poorly in situations where the trellis is large, as in WCDMA of the UMTS system, for instance.

US 5901182 A and P. Bengongh: Sorting-Based VLSI Architectures for the M-algorithm and T-algorithm Trellis Decoders, IEEE Trans. Comm, Vol.43, NO. 2/3/4, 1995 disclose efficient sorting architectures for the M-Algorithm.

The trellis structure is used not only in the decoding of convolutional codes, but also in several other applications, such as channel equalization. The same above-mentioned problems also apply to these solutions, when the size of the trellis increases.

Thus, to minimize the size and power consumption of devices, more efficient methods than before are needed for searching through a trellis, methods that are fast and whose implementation as ASIC structures does not require much space.

BRIEF DESCRIPTION OF THE INVENTION

it is an object of the invention to provide a method and an apparatus implementing the method in such a manner that a restricted trellis search is possible to perform more advantageously than before. This is achieved by a method for enhancing a search through a trellis, in which at each stage of the trellis a certain set of state indexes of the stage are selected for continuation. The method of the invention comprises the steps of dividing the state indexes being processed into more than one subset at each stage of the trellis, defining the path metrics of the state indexes in the subsets, selecting from each subset a predefined number of state indexes for continuation on the basis of the metrics.

The invention also relates to an arrangement for enhancing a search through a trellis in a detector that is arranged at each stage of the trellis to select a certain set of state indexes of the stage for continuation. In the arrangement of the invention, the detector is arranged when calculating each stage of the trellis to divide the state indexes being processed into more than one subset, to define the path metrics of the state indexes in the subsets, to select from each subset a predefined number of state indexes for continuation on the basis of the metrics.

Preferred embodiments of the invention are described in the dependent claims.

The invention is based on the idea that by dividing the state indexes being processed into subsets, it is possible to reduce substantially the number of necessary comparisons. For instance, for a 256-state code when using 32 subsets having 8 states in each, the number of comparisons required for sorting is 32 * (8*8) /2, i.e. 1024. In comparison with the 32768 comparisons required in the prior art, the reduction is 32fold. In addition, because some preferred embodiments do not require a full sort, but only the definition of the best values in each subset, the number of computations can further be reduced.

The method and arrangement of the invention thus provide several advantages. Implementing preferred solutions of the invention in a receiver is simple. The M algorithm has not been utilized much in practice, because of its complexity. By means of the present solution, the M algorithm can be efficiently utilized. Because the solution examines fewer states than the Viterbi algorithm, less memory is required for calculating the paths. This results in savings in equipment costs. Further, the power consumption of the receiver decreases, because there is less computation and less memory space is needed. However, the solution provides a sufficient performance that in practice is equal to that of the earlier methods.

Especially in connection with high data rates, the present solution provides a significant benefit, because then the size of the trellis is typically large. Large trellises also need to be used for instance when several antennas, complex modulation methods and strong codes are used in transmission and reception. Decoding large trellises increases the number of required computations, and in such a situation, the present solution helps reduce the number of computations.

The solutions of the preferred embodiments can be utilized in all applications using a trellis. In addition to the above-mentioned decoding of convolutional coding, such applications include the decoding of other types of codes, equalization, multiuser decoding and speech recognition.

DESCRIPTION OF FIGURES

The invention will now be described in more detail by means of preferred embodiments, with reference to the attached drawings, in which

Figure 1 shows an example of a telecommunications system, to which the preferred embodiments can be applied,
Figure 2 shows an example of a transmitter and receiver,
Figure 3 illustrates a trellis,
Figure 4 illustrates the method of the preferred embodiments,
Figure 5 is a flow chart illustrating the method of the preferred embodiments,
Figure 6 shows an example of the weights of the paths in a trellis stage,
Figure 7 illustrates the performance of an embodiment, and
Figures 8A to 8D show different embodiments.

DESCRIPTION OF THE PREFERRED EMBODIMENTS

The method of the invention can be applied to any system having a trellis structure. One target of use is decoding, for instance the decoding of a convolutional code, block code, turbo code or space-time code. Other targets of use include equalization, speech recognition algorithms, source encoding, and trellis-coded quantization (TCQ). In the following, the invention is described by applying it to a digital cellular system, such as the GSM system or the UMTS system, in decoding a convolutional code, without limiting the invention to this, however.

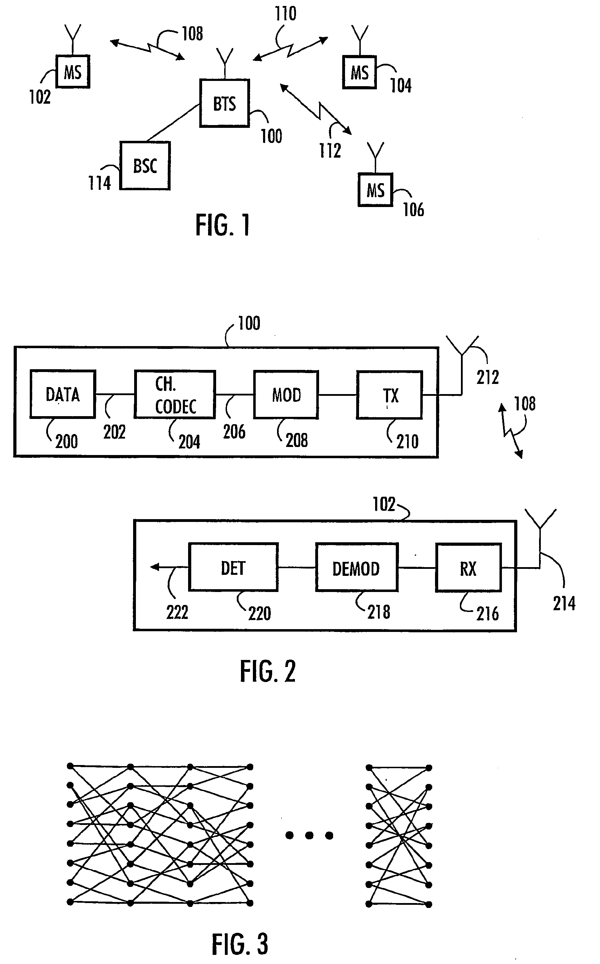

Figure 1 shows the parts of the structure of the cellular system that are essential for the invention. The system comprises a base station 100 and a set of generally mobile subscriber terminals 102 to 106 that have a bi-directional connection 108 to 112 to the base station. The base station switches the connections of the terminals to a base station controller 114 that switches them on to other parts of the system and to the fixed network. The base station controller 114 controls the operation of one or more base stations.

With reference to Figure 2, let us examine an example of the transmitter 100 and a receiver 102, to which the solution of the preferred embodiments of the invention can be applied. In the example of the figure, the transmitter is thus a base station and the receiver a subscriber terminal, but the preferred embodiments can also be applied when the receiver is a base station receiver. The transmitter 100 and receiver 102 thus communicate over a radio channel 108 in the example of Figure 2. The transmitter 100 comprises a data source 200 that can be a speech coder or some other data source. A signal 202 to be transmitted is obtained from the output of the data source and taken to a channel encoder 204, which in this example is a convolutional encoder. The coded symbols 206 are taken to a modulator 208, in which the signal is modulated in a known manner. The modulated signal is taken to radio frequency parts 210, in which it is amplified and transmitted to the radio path 108 by means of an antenna 212.

On the radio path 108, the signal is corrupted by the propagation channel. The receiver 102 comprises an antenna 214, with which it receives the signal that is taken to a demodulator 218 through radio frequency parts 216. The demodulated signal is taken to a detector 220, in which the signal is decoded, equalized and detected according to the preferred embodiments of the invention. From the detector, the signal 222 is taken on to other parts of the receiver.

Next, an example of using a trellis with a Viterbi decoder is described in more detail by means of Figure 3. The figure shows an 8-state trellis diagram as an example. The trellis diagram is determined on the basis of the used code; in the figure, each point has two incoming and two outgoing routes, i.e. the code in question is a code of a 1/n coding ratio. Each column can be called a stage of the trellis. The Viterbi algorithm is solved in a trellis diagram by progressing in stages from left to right or right to left. Each point can be reached via two different routes, and the better of the incoming routes is selected in each point and stored in memory. The selection is based on the metrics mentioned earlier. Path metrics represent the probability of the set of symbols in the received signal leading to the state described by the node in question. Branch metrics, in turn, represent the probabilities of different transitions. The metrics of the incoming routes are thus calculated at each point in such a manner that the branch metric of the transition between the previous node and the node being processed is added to the path metric of the previous node on the route. Depending on the method, either the larger or the smaller of these is selected for continuation.

In the conventional Viterbi algorithm, all paths and nodes are checked. When using the M algorithm, only M paths are selected for continuation at each stage. If M equals the number of all states, then this is a plain Viterbi algorithm. The M algorithm is known per se to a person skilled in the art and is not described in more detail herein. Reference is made to publication Schlegel: Trellis coding, IEEE Press, ISBN: 0-7803-1052-7, pages 153 to 189.

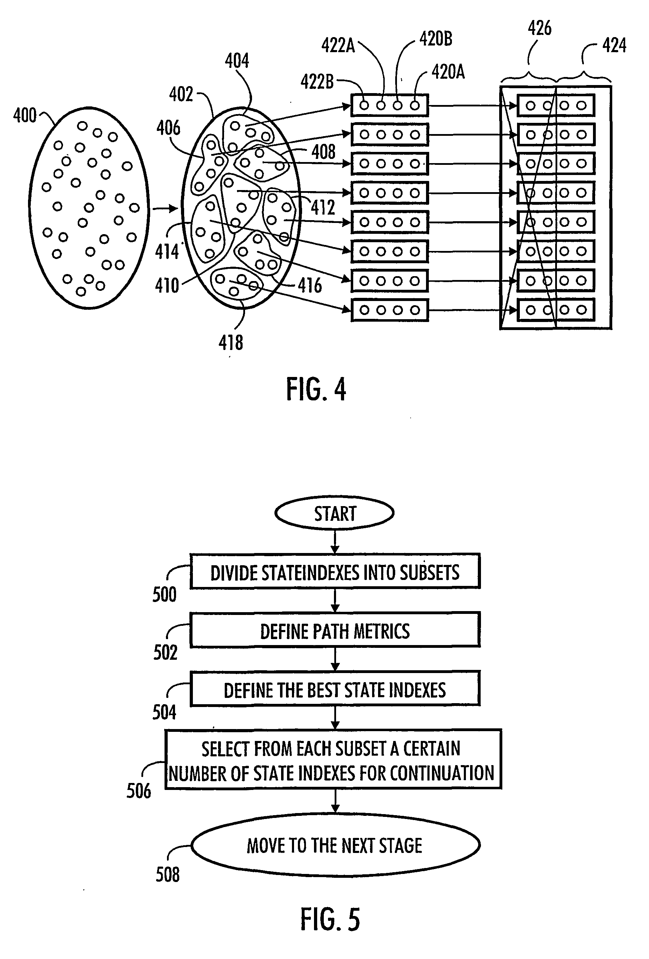

Let us now examine a preferred embodiment of the invention by means of Figures 4 and 5. Let us assume that one stage of a trellis is processed in the decoding. The state indexes 400 of the stage are thus processed in the decoding. This may concern all state indexes of the stage in question or a part of them, depending on the code and the value of M. In the figure, each point is one state index.

In step 500 (corresponds to step 402 of Figure 4), the state indexes to be processed are divided into more than one subset 404 to 418. In the example of Figure 4, there are eight subsets. In this case, each subset has an equal number of state indexes, i.e. four. In step 502, the path metrics of the state indexes are defined in the subsets. In step 504, the state indexes are sorted in the subsets in such a manner that a predefined number of the best state indexes in each subset are identified. In the example of Figure 4, the best state indexes of the first subset 404 are 420A and 420B and the worst state indexes are 422A and 422B. It should be noted that the state indexes need not be set in an exact order, only the best state indexes, i.e. 420A and 420B, need to be found. In step 506, these specific state indexes of each subset are selected for continuation. In the example of Figure 4, two best state indexes 424 are identified from the four state indexes in each subset and selected for continuation. They do not need to be put in any specific order. When all states have been processed, M best state indexes are selected for continuation. In this example, two indexes per row are selected for continuation, but the selected number can be some other number. The worst indexes 426 are discarded. The number of the indexes selected for continuation need not be two or even half of the elements in each subset, as is the case in the example of Figure 4. In step 508, the next stage of the trellis is processed.

Let us next examine how the state indexes 400 being processed are divided into different subsets. In one embodiment, the division is performed randomly. However, so as to make the partial sort and the selection of a certain number of indexes occurring in the subsets as efficient as possible, the metrics of the state indexes should preferably differ from each other. If the state indexes differ from each other only a little, "good" and "bad" state indexes cannot very reliably be distinguished from each other. This is why some preferred embodiments of the invention use the following criteria when selecting state indexes for subsets.

Let us assume that herein S is the number of states in the used convolutional code. Let us mark with the letter $D$ the maximum of all the least-weight paths from state 0 to state $s$, where $s$=0, 1,..., $S$-1. Let $r$ be the received signal, i.e. the signal in the input of the decoder, and correspond to one channel symbol. Due to the linearity of the code, the difference between any two path metrics is smaller than or equal to

$$D \cdot \max |r|.$$

Herein, ‖ refers to an absolute value. The above value thus represents the highest difference between any two path metrics. One possible criterion in selecting state indexes for subsets is that first the shortest distances between the path metrics are defined for the state indexes to be put into each subset and then the state indexes are selected for the subsets in such a manner that the shortest unencoded distance between subsets is maximized.

A second possible criterion is to define the shortest distances between the path metrics for the state indexes to be put into each subset and to then select the state indexes for the subsets in such a manner that the sum of the smallest unencoded distances of the subsets is maximized.

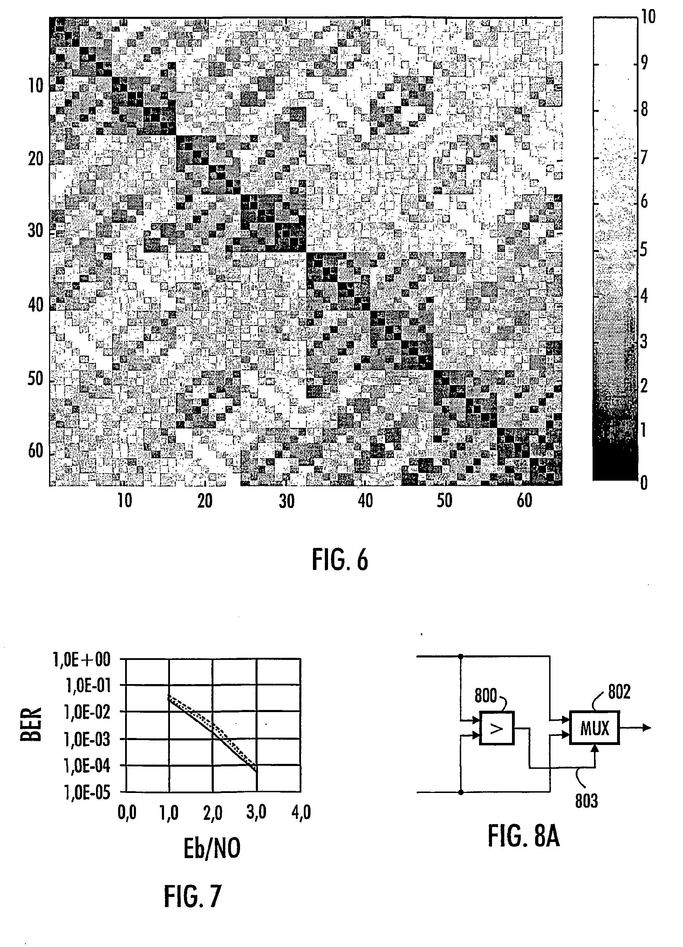

Let $D_{s,\,s'}$ be the weight of the path which is the difference between the found paths that end in the states s and s' with the smallest unencoded weight. In other words, it is the weight for the difference that is between the paths that end in the states s and s' and branch off from each other at the earliest possible point when examined backward from the points s and s'. Figure 6 illustrates the value of $D_{s,s'}$ with all possible values of s and s', when the code is a 64-state code with polynomials 133 and 171. The figure shows a 64x64 matrix, in which the horizontal axis and the vertical axis both have 64 state indexes. The degree of darkness of each square describes the value of $D_{s,\,s'}$ in such a manner that in the lightest squares the value of $D_{s,\,s'}$ is 10 and in the darkest squares it is 0. On the divider of Figure 6, $D_{s,\,s'}$ obtains the value 0, because there $s = s'$.

The figure shows that $D_{s,\,s'}$ behaves fractally. The matrix of Figure 6 can be divided into four squares and these further into four squares, and each square keeps the symmetry of the entire square.

In a preferred embodiment, the state indexes are selected for the subsets in such a manner that within each subset, the state indexes differ from each other by a value that is a power of two. Thus, if there are 256 states, for instance, then the states {i, i + 32, i + 64, i + 96, i + 128, i + 192, i + 224} are selected for state i.

Let us next examine an example that illustrates a simulation performed by means of a solution of a preferred embodiment. Let us assume that the coding ratio is 1/2, the length of the frame 300 bits, and that the channel has white Gaussian noise. The code comprises 256 states, and the value of M is half the number of states, i.e. 128. The number of subsets is 32, each having 8 elements. The states for a subset are selected according to the earlier paragraph, i.e. the states {i, i + 32, i + 64, i + 96, i + 128, i + 192, i + 224} are selected for state i. This means that the sum of $D_{s,\,s'}$ between all states of the subset obtains the value 240. The minimum value of $D_{s,\,s'}$ in the subset is 7, and the maximum is 10.

The above conditions produce the performance according to Figure 7. The horizontal axis has Eb/N0 that obtains the values between 0.0 and 4.0, and the vertical axis has the bit error rate BER that obtains values between $1.0 \cdot 10^{-5}$ to 1.0. The figure shows curves for a Viterbi algorithm (solid line), M algorithm with a full sort (dotted line) and M algorithm with eight subsets (dashed line). As can be seen, the performance of each is nearly the same. The subset solution is, however, the simplest to implement.

Let us next examine some implementations with which a desired number of state indexes in a subset can be selected for continuation. Let us assume herein that 2M=S, i.e. half of the state indexes in each subset is always selected for continuation. This restriction is only selected to simplify the example and does not restrict the preferred embodiments in general.

Figure 8A shows an implementation that is suitable for a situation in which the size of the subset is two elements, i.e. state indexes. The implementation comprises a comparator 800 and a multiplexer 802. The values A and B of the subset are brought to the comparator and multiplexer. The value of the comparator output depends on which of the input signals is larger, and with the output signal 803, a desired value, A or B, is directed to the output of the multiplexer.

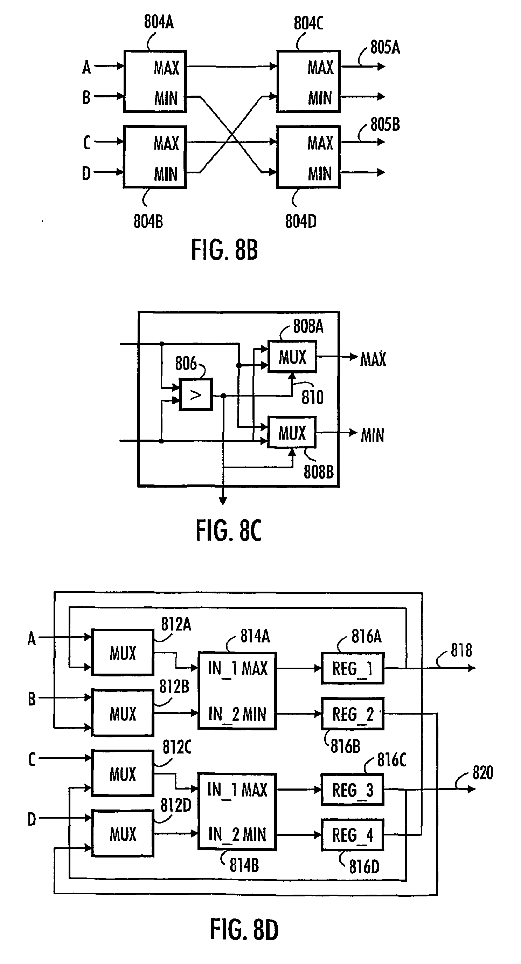

Figure 8B shows an implementation that is suitable for a situation in which the size of the subset is four elements. The implementation comprises four MAXMIN units 804A to 804D. Each unit compares the input values and provides a higher value in the MAX output and a lower value in the MIN output. Four values, A, B, C and D, are first compared in pairs with each other in the units 804A and 804B. After these comparisons, the values are fed crosswise to the units 804C and 804D. The value 805A, 805B from each MAX output is selected for continuation and the values from the MIN outputs are discarded.

Figure 8C illustrates the implementation of the MAXMIN unit. It can be implemented using one comparator 806 and two multiplexers 808A and 808B whose outputs are controlled by the comparator 806. The comparator provides in its output, for instance, the signal '1', if A is higher than B, and the signal '0', if B is higher than A. This output signal 810 is connected to the control input of the multiplexers 808A and 808B. When the control signal of the multiplexers has the value '0', the output of the MAX multiplexer 808A has the value B and the output of the MIN multiplexer 808A has the value A.

Figure 8D shows an alternative implementation to the solution of Figure 8B. Functionally, the implementation of Figure 8D is the same as the solution of Figure 8B, but it is achieved with a substantially smaller number of ports. The implementation comprises four parallel multiplexers 812A to 812D, two parallel MAXMIN units 814A, 814B, and four delay units 816 A to 816D. In this figure, a clock cycle control goes to the delay units and multiplexers, but it is not drawn in the figure for the sake of clarity.

First the inputs A, B, C and D of the multiplexers 812A to 812D are connected to the MAXMIN units, and the outputs of the latter are taken to the delay units 816A to 816D. The outputs of the delay units are taken back to the multiplexers 812A to 812D that during the next clock cycle connect these inputs to the MAXMIN units. The outputs of the delay units 816A and 816C provide the values 818, 820 selected for continuation. The consecutive MAXMIN units of Figure 8B are replaced by one pair that is used twice. In the example of the figure, sorting is performed in folds. When data is cycled several times, less hardware resources are required. Sorting is slower, but the silicon surface area is smaller.

In the preferred embodiments of the invention, the detector of the receiver is thus arranged to divide the state indexes being processed into more than one subset, to define path metrics for the state indexes in the subsets and to select from each subset a predefined number of state indexes for continuation on the basis of the metrics. These operations can be performed in the detector either by program or as a hardware implementation. The connections and programming can preferably already be done when designing the detector for the receiver, because they usually need not be changed during use.

Even though the invention has been explained in the above with reference to examples in accordance with the accompanying drawings, it is apparent that the invention is not restricted to them but can be modified in many ways within the scope of the inventive idea disclosed in the attached claims.

**Claims**

1. A method for enhancing a search through a trellis, in which at each stage of the trellis a certain set of state indexes of the stage are selected for continuation, **characterized by** the method of the invention comprising the steps of
dividing (500) the state indexes being processed into more than one subset (404 to 418) at each stage of the trellis,
defining (502) the path metrics of the state indexes in the subsets,
selecting (504, 506) from each subset a predefined number of state indexes for continuation on the basis of the metrics.

2. A method as claimed in claim 1,**characterized by** defining the path metrics of the state indexes in each stage,
defining the shortest distances between the path metrics for the state indexes to be put into each subset,
selecting the state indexes for the subsets in such a manner that the shortest distance between subsets is maximized.

3. A method as claimed in claim 1, **characterized by** defining the path metrics of the state indexes in each stage,
defining the shortest distances between the path metrics for the state indexes to be put into each subset,
selecting the state indexes for the subsets in such a manner that the sum of the shortest distances between subsets is maximized.

4. A method as claimed in claim 1, **characterized by** selecting the state indexes for the subsets in such a manner that within each subset, the state indexes differ from each other by a value that is a power of two.

5. A method as claimed in claim 1, **characterized by** sorting the state indexes by size in each subset.

6. A method as claimed in claim 1, **characterized by** selecting for continuation from each subset a predefined number of state indexes having the largest path metrics.

7. A method as claimed in claim 1, **characterized by** selecting for continuation from each subset half of the state indexes in the subset.

8. A method as claimed in claim 1, **characterized in that** the decoding of a received signal is performed by means of the trellis.

9. A method as claimed in claim 1, **characterized in that** the decoding of a convolutionally coded signal is performed by means of the trellis.

10. A method as claimed in claim 1, **characterized in that** the equalization of a received signal is performed by means of the trellis.

11. An arrangement for enhancing a search through a trellis in a detector (220) that is arranged at each stage of the trellis to select a certain set of state indexes of the stage for continuation, **characterized in that** the detector (220) is arranged when calculating each stage of the trellis
to divide the state indexes being processed into more than one subset (404 to 418),
to define the path metrics of the state indexes in the subsets (404 to 418),
to select from each subset a predefined number of state indexes for continuation on the basis of the metrics.

12. An arrangement as claimed in claim 11, **characterized in that** the detector (220) is arranged

to define the path metrics of the state indexes in each stage,

to define the shortest unencoded distances between path metrics for the state indexes to be put into each subset (404 to 418),

to select the state indexes for the subsets in such a manner that the shortest distance between subsets is maximized.

13. An arrangement as claimed in claim 11, **characterized in that** the detector (220) is arranged
to define the path metrics of the state indexes in each stage,
to define the shortest unencoded distances between path metrics for the state indexes to be put into each subset (404 to 418),
to select the state indexes for the subsets in such a manner that the sum of the shortest distances between subsets is maximized.

14. An arrangement as claimed in claim 11, **characterized in that** the detector (220) is arranged to select the state indexes for the subsets in such a manner that within each subset, the state indexes differ from each other by a value that is a power of two.

15. An arrangement as claimed in claim 11, **characterized in that** the detector (220) is arranged to perform the decoding of a received signal.

16. An arrangement as claimed in claim 11, **characterized in that** the detector (220) is arranged to perform the equalization of a received signal.

17. An arrangement as claimed in claim 11, **characterized in that** the detector (220) is arranged to perform multi-user decoding.

**Patentansprüche**

1. Verfahren zum Erweitern einer Suche durch Trellis, wobei an jeder Stufe des Trellis eine bestimmte Gruppe von Zustandsindizes der Stufe zur Fortführung ausgewählt werden, **dadurch gekennzeichnet, dass** das Verfahren gemäß der Erfindung die Schritte umfasst
Aufteilen (500) der gerade bearbeiteten Zustandsindizes in mehr als eine Untergruppe (404 bis 418), an jeder Stufe des Trellis,
Definieren (502) der Pfadmetrik der Zustandsindizes in der Untergruppe,
Auswählen (504, 506) einer vorbestimmten Anzahl von Zustandsindizes für jede Untergruppe zur Fortführung auf Grundlage der Metrik.

2. Verfahren nach Anspruch 1, **gekennzeichnet durch**

Definieren der Pfadmetrik der Zustandsindizes in jeder Stufe,
Definieren der kürzesten Distanz zwischen den Pfadmetriken für die in jede Untergruppe einzufügenden Zustandsindizes,
Auswählen der Zustandsindizes für die Untergruppen in der Weise, dass die kürzeste Distanz zwischen Untergruppen maximiert wird.

3. Verfahren nach Anspruch 1, **gekennzeichnet durch**
Definieren der Pfadmetrik der Zustandsindizes in jeder Stufe,
Definieren der kürzesten Distanz zwischen den Pfadmetriken für die in jede Untergruppe einzufügenden Zustandsindizes,
Auswählen der Zustandsindizes für die Untergruppen in solcher Weise, dass die Summe der kürzesten Distanzen zwischen Untergruppen maximiert wird.

4. Verfahren nach Anspruch 1, **gekennzeichnet durch** Auswählen der Zustandsindizes für die Untergruppen in solcher Weise, dass sich innerhalb jeder Untergruppe die Zustandsindizes um einen einer Potenz von zwei entsprechenden Wert voneinander unterscheiden.

5. Verfahren nach Anspruch 1, **gekennzeichnet durch** Sortieren der Zustandsindizes nach der Größe in jeder Untergruppe.

6. Verfahren nach Anspruch 1, **gekennzeichnet durch** Auswählen einer vorbestimmten Anzahl von Zustandsindizes mit den größten Pfadmetriken aus jeder Untergruppe zur Fortführung.

7. Verfahren nach Anspruch 1, **gekennzeichnet durch** Auswählen der Hälfte der Zustandsindizes in der Untergruppe aus jeder Untergruppe zur Fortführung.

8. Verfahren nach Anspruch 1, **dadurch gekennzeichnet, dass** das Dekodieren eines empfangenen Signals mittels des Trellis durchgeführt wird.

9. Verfahren nach Anspruch 1, **dadurch gekennzeichnet, dass** das Dekodieren eines faltungskodierten Signals mittels des Trellis durchgeführt wird.

10. Verfahren nach Anspruch 1, **dadurch gekennzeichnet, dass** das Ausgleichen eines empfangenen Signals mittels des Trellis durchgeführt wird.

11. Anordnung zum Erweitern einer Suche durch Trellis in einem Detektor (220), der so ausgestaltet ist, dass an jeder Stufe des Trellis eine bestimmte Gruppe von Zustandsindizes der Stufe zur Fortführung gewählt wird, **dadurch gekennzeichnet, dass** der Detektor (220) bei der Berechnung einer jeden Stufe des Trellis ausgestaltet ist

zum Aufteilen der gerade bearbeiteten Zustandsindizes in mehr als eine Untergruppe (404 bis 418),

zum Definieren der Pfadmetrik der Zustandsindizes in den Untergruppen (404 bis 418),

zum Auswählen einer vorbestimmten Anzahl von Zustandsindizes aus jeder Untergruppe zur Fortführung auf Grundlage der Metrik.

**12.** Anordnung nach Anspruch 11, **dadurch gekennzeichnet, dass** der Detektor (220) ausgestaltet ist zum Definieren der Pfadmetrik der Zustandsindizes in jeder Stufe,

zum Definieren der kürzesten unkodierten Distanz zwischen Pfadmetriken für die in jede Untergruppe einzufügenden Zustandsindizes (404 bis 418),

zum Auswählen der Zustandsindizes für die Untergruppen in solcher Weise, dass die kürzeste Distanz zwischen Untergruppen maximiert wird.

**13.** Anordnung nach Anspruch 11, **dadurch gekennzeichnet, dass** der Detektor (220) ausgestaltet ist zum Definieren der Pfadmetrik der Zustandsindizes in jeder Stufe,

zum Definieren der kürzesten unkodierten Distanz zwischen Pfadmetriken für die in jede Untergruppe einzufügenden Zustandsindizes (404 bis 418),

zum Auswählen der Zustandsindizes für die Untergruppen in solcher Weise, dass die Summe der kürzesten Distanzen zwischen Untergruppen maximiert wird.

**14.** Anordnung nach Anspruch 11, **dadurch gekennzeichnet, dass** der Detektor (220) ausgestaltet ist zum Auswählen der Zustandsindizes für die Untergruppen in solcher Weise, dass innerhalb jeder Untergruppe die Zustandsindizes um einen einer Potenz von zwei entsprechenden Wert voneinander abweichen.

**15.** Anordnung nach Anspruch 11, **dadurch gekennzeichnet, dass** der Detektor (220) ausgestaltet ist zum Durchführen der Dekodierung eines empfangenen Signals.

**16.** Anordnung nach Anspruch 11, **dadurch gekennzeichnet, dass** der Detektor (220) ausgestaltet ist zum Durchführen des Ausgleichens eines empfangenen Signals.

**17.** Anordnung nach Anspruch 11, **dadurch gekennzeichnet, dass** der Detektor (220) ausgestaltet ist zum Durchführen einer Mehrfach-Nutzer-Dekodierung.

**Revendications**

**1.** Procédé permettant d'améliorer une exploration d'un treillis, dans lequel à chaque niveau du treillis, un certain ensemble d'indicateurs d'état du niveau est sélectionné à des fins de continuation, **caractérisé en ce que** le procédé selon l'invention comprend les étapes suivantes consistant à

diviser (500) les indicateurs d'état traités en plus d'un sous-ensemble (404 à 418) à chaque niveau du treillis,

définir (502) la métrique d'acheminement des indicateurs d'état dans les sous-ensembles,

sélectionner (504, 506) dans chaque sous-ensemble un nombre prédéfini d'indicateurs d'état à des fins de continuation sur la base de la métrique.

**2.** Procédé selon la revendication 1, **caractérisé par** la définition de la métrique d'acheminement des indicateurs d'état dans chaque niveau,

la définition des distances les plus courtes entre la métrique d'acheminement pour les indicateurs d'état devant être placés dans chaque sous-ensemble,

la sélection des indicateurs d'état pour les sous-ensembles d'une telle manière que la distance la plus courte entre les sous-ensembles soit maximisée.

**3.** Procédé selon la revendication 1, **caractérisé par** la définition de la métrique d'acheminement des indicateurs d'état dans chaque niveau,

la définition des distances les plus courtes entre la métrique d'acheminement pour les indicateurs d'état devant être placés dans chaque sous-ensemble,

la sélection des indicateurs d'état pour les sous-ensembles d'une telle manière que la somme des distances les plus courtes entre les sous-ensembles soit maximisée.

**4.** Procédé selon la revendication 1, **caractérisé par** la sélection des indicateurs d'état pour les sous-ensembles d'une telle manière que dans chaque sous-ensemble, les indicateurs d'état diffèrent les uns des autres par une valeur qui est une puissance de deux.

**5.** Procédé selon la revendication 1, **caractérisé par** le triage des indicateurs d'état par taille dans chaque sous-ensemble.

**6.** Procédé selon la revendication 1, **caractérisé par** la sélection à des fins de continuation dans chaque sous-ensemble d'un nombre prédéfini d'indicateurs d'état ayant la métrique d'acheminement la plus grande.

**7.** Procédé selon la revendication 1, **caractérisé par** la sélection à des fins de continuation dans chaque sous-ensemble de la moitié des indicateurs d'état dans le sous-ensemble.

**8.** Procédé selon la revendication 1, **caractérisé en ce que** le décodage d'un signal reçu est réalisé à l'aide du treillis.

**9.** Procédé selon la revendication 1, **caractérisé en ce que** le décodage d'un signal codé de manière convolutionnelle est réalisé à l'aide d'un treillis.

**10.** Procédé selon la revendication 1, **caractérisé en ce que** l'égalisation d'un signal reçu est réalisée à l'aide du treillis.

**11.** Dispositif permettant d'améliorer une exploration d'un treillis dans un détecteur (220) qui est disposé à chaque niveau du treillis pour sélectionner un certain ensemble d'indicateurs d'état du niveau à des fins de continuation, **caractérisé en ce que** le détecteur (220) est disposé pendant le calcul de chaque niveau du treillis
pour diviser les indicateurs d'état traités en plus d'un sous-ensemble (404 à 418),
pour définir la métrique d'acheminement des indicateurs d'état dans les sous-ensembles (404 à 418),
pour sélectionner dans chaque sous-ensemble un nombre prédéfini d'indicateurs d'état à des fins de continuation sur la base de la métrique.

**12.** Dispositif selon la revendication 11, **caractérisé en ce que** le détecteur (220) est disposé
pour définir la métrique d'acheminement d'indicateurs d'état dans chaque niveau,
pour définir les distances non encodées les plus courtes entre la métrique d'acheminement pour les indicateurs d'état devant être placés dans chaque sous-ensemble (404 à 418),
pour sélectionner les indicateurs d'état pour les sous-ensembles d'une telle manière que la distance la plus courte entre les sous-ensembles soit maximisée.

**13.** Dispositif selon la revendication 11, **caractérisé en ce que** le détecteur (220) est disposé
pour définir la métrique d'acheminement d'indicateurs d'état dans chaque niveau,
pour définir les distances non encodées les plus courtes entre la métrique d'acheminement pour les indicateurs d'état devant être placés dans chaque sous-ensemble (404 à 418),
pour sélectionner les indicateurs d'état pour les sous-ensembles d'une telle manière que la somme des distances les plus courtes entre les sous-ensembles soit maximisée.

**14.** Dispositif selon la revendication 11, **caractérisé en ce que** le détecteur (220) est disposé pour sélectionner les indicateurs d'état pour les sous-ensembles d'une telle manière que dans chaque sous-ensemble, les indicateurs d'état diffèrent les uns des autres par une valeur qui est une puissance de deux.

**15.** Dispositif selon la revendication 11, **caractérisé en ce que** le détecteur (220) est disposé pour réaliser le décodage d'un signal reçu.

**16.** Dispositif selon la revendication 11, **caractérisé en ce que** le détecteur (220) est disposé pour réaliser l'égalisation d'un signal reçu.

**17.** Dispositif selon la revendication 11, **caractérisé en ce que** le détecteur (220) est disposé pour réaliser le décodage multiutilisateur.

FIG. 1

FIG. 2

FIG. 3

FIG. 4

FIG. 5

**FIG. 6**

**FIG. 7**

**FIG. 8A**

FIG. 8B

FIG. 8C

FIG. 8D

EP 1 456 958 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5901182 A

### Non-patent literature cited in the description

- **S.J. Simmons.** A Nonsorting VLSI structure for implementing the (M,L) algorithm. *IEEE Journal on Selected Areas in Communications,* April 1996, vol. 6 (3), 538-546

- **P. Bengongh.** Sorting-Based VLSI Architectures for the M-algorithm and T-algorithm Trellis Decoders. *IEEE Trans. Comm,* 1995, vol. 43 (2/3/4
- **Schlegel.** Trellis coding. IEEE Press, 153-189